# EUROPEAN PATENT APPLICATION

(11) **EP 1 376 462 A1**
(43) Date of publication of application: **02.01.2004**
(21) Application number: 02291536.7
(22) Date of filing: 19.06.2002
(51) Int. Cl.: G06K 19/077

(54) **Method for manufacturing a tape**

(71) Applicant: SCHLUMBERGER Systèmes, 92120 Montrouge (FR)
(72) Inventor: Audoux, Jean-Noel, 45100 Orléans (FR); Ligneau, Guillaume, 45650 Saint Jean Le Blanc (FR); Reignoux, Yves, 45370 Clery Saint-André (FR)

(57) **Abstract**

A tape (T) to which a plurality of elements (C) are affixed by means of a glue in a solid state is manufactured in the following manner. In a gluing step, in which elements (C) are glued to a basic tape (T) by means of a glue in a liquid state so as to obtain a glued tape. The gluing step is followed by a winding step and a heating step. In the winding step, the glued tape (T) is wound while the glue is in a state between the liquid state and the solid state, so as to obtain a winded glued tape. In the heating step, in the winded glued tape is heated, so that the glue reaches the solid state.

## Description

### FIELD OF THE INVENTION

The invention relates to manufacturing a tape to which a plurality of elements is affixed. The invention may be applied in, for example, the manufacturing of smart cards.

### BACKGROUND OF THE INVENTION

Methods of manufacturing smart cards generally involve a tape with electrical contacts to which a plurality of chips is affixed. Such a tape is often referred to as a "leadframe".
In a gluing step, the chips are glued to the tape by means of a glue in a liquid state, so as to obtain a glued tape.
In a heating step, the glued tape goes through an in-line oven, so that the glue reaches a solid state.
The tape thus obtained is cut so as to obtain electrical modules.

### SUMMARY OF THE INVENTION

An object of the invention is to reduce the costs.

According to one aspect of the invention, a method of manufacturing a tape (T) to which a plurality of elements (C) are affixed by means of a glue in a solid state, the method comprising a gluing step, in which elements (C) are glued to a basic tape (T) by means of a glue in a liquid state so as to obtain a glued tape, the method being characterised in that the gluing step is followed by:
- a winding step, in which the glued tape (T) is wound while the glue is in a state between the liquid state and the solid state, so as to obtain a winded glued tape; and
- a heating step, in which the winded glued tape is heated, so that the glue reaches the solid state.

The method according to the invention does not require in-line oven. Such an oven is relatively big and costly. Consequently, the invention allows to reduce costs.

### BRIEF DESCRIPTION OF THE DRAWINGS

Fig. 1 illustrates a tape;
Fig. 2 illustrates a glue depositing step and a chip depositing step;
Fig. 3 illustrates a first winding step;
Fig. 4 illustrates a first heating step;
Fig. 5 illustrates a connecting step;
Fig. 6 illustrates a resin depositing step;
Fig. 7 illustrates a second winding step;
Fig. 8 illustrates a second heating step;
Fig. 9 illustrates a cutting step and an embedding step; and
Fig. 10 is a cross section drawing, which illustrates a reel.

### DETAILED DESCRIPTION

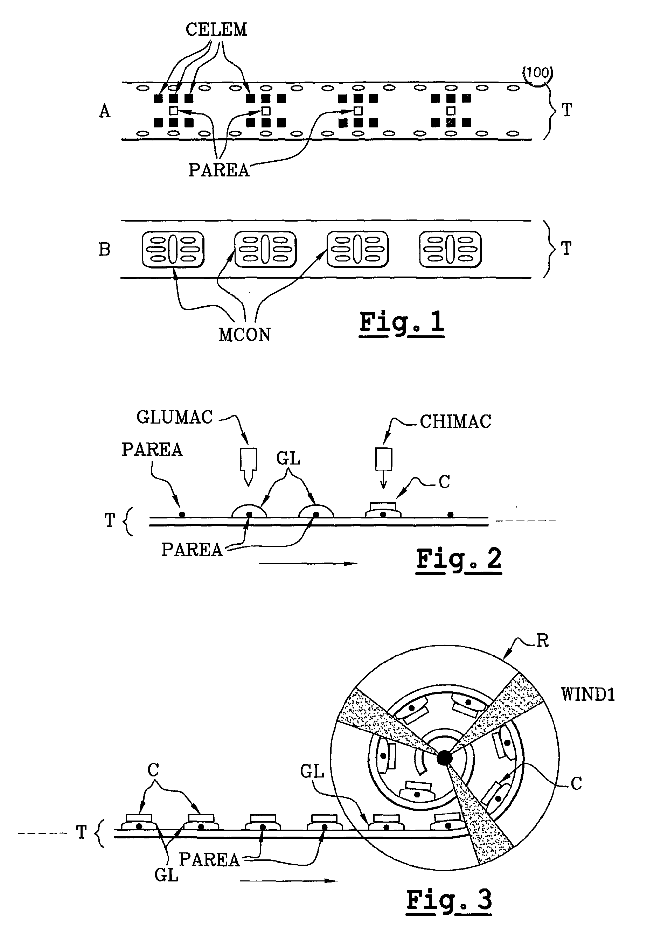

Figure 1 illustrates the structure of a basic tape T. The basic tape T comprises a first side A and a second side B. The first side A comprises a plurality of conducting elements CELEM and a plurality of predefined areas PAREA. The side B comprises metallic contacts MCON. The conducting element CELEM are electrically connected to the metallic contacts MCON. The basic tape T may comprise, for example, epoxy resin impregnated with glass fiber.

Figure 2 illustrates a glue depositing step, in which a glue depositing machine GLUMAC deposits glue GL in a substantially liquid state on a predefined area PAREA. The glue GL can be a thermo-hardening glue, for example, a hot melt glue or an epoxy-based glue. When heated, a thermo-hardening glue is a glue which polymerizes in a non-reversible manner. The glue thus becomes substantially solid. Figure 2 further illustrates a chip depositing step, in which a chip depositing machine CHIMAC deposits a chip C on a glued predefined area PAREA.

Figure 3 illustrates a first tape winding step WIND1, which follows the chip depositing step CHIPDEP. In the first winding step WIND1, the basic tape T comprising the glued chips C is wound in a reel R. The glue is between the liquid state and the solid state. That is, the glue is not yet fully hardened. Preferably, the viscosity of the glue is sufficiently high so that the glue does not spread out too much and so that the chips remain affixed to the tape. In practice, the viscosity required depends on the surface tension of the tape and the surface tension of the chips. The higher the surface tension is, the higher the viscosity needs to be.
In the glue depositing step GLUDEP the glue GL can have, for example, a viscosity of 8000 mPa/s at a temperature of 25°C for chips having an average surface tension of roughly about 30 mN/m.

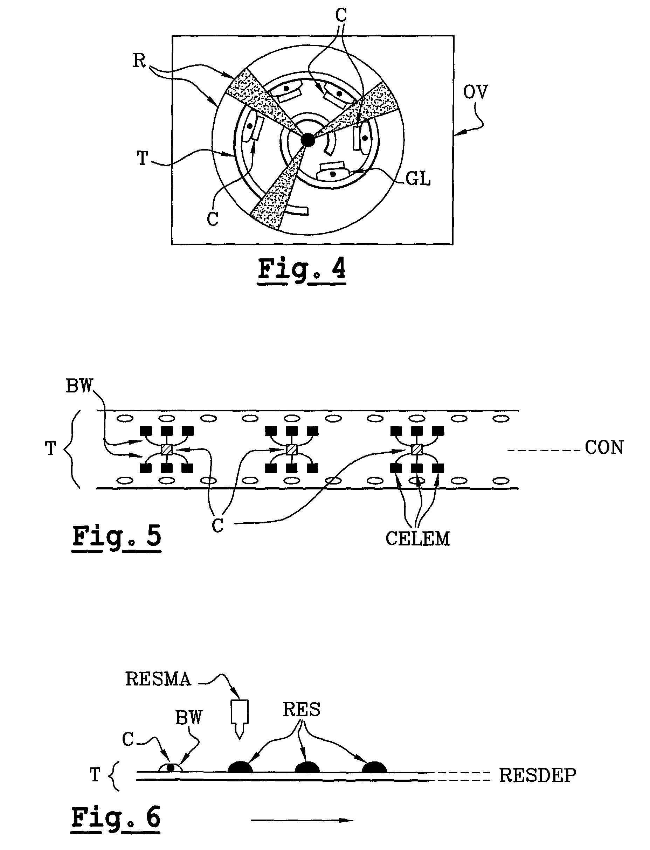

Figure 4 illustrates a first heating step, which follows the first tape winding step WIND1. In the first heating step, the reel R comprising the basic tape T is placed in an oven OV. The temperature may be comprised, for example, between 120°C and 150°C. The basic tape T can be heated, for example, between 60 minutes and 90 minutes. Advantageously the oven OV is just big enough to contain the reel R. No in-line oven is needed thus saving place and money. After the first heating step, the glue GL has reached its definitive, solid state so that the chips C are affixed to the basic tape T.

Figure 5 illustrates a connecting step CON, in which the chips C are connected to the connecting elements CELEM with, for example, bonding wires BW.

Figure 6 further illustrates a resin depositing step RESDEP, in which a resin depositing machine RESMAC deposits resin RES in a substantially liquid state on the connected chips C to protect them. The resin belongs, for example, to the epoxyde chemical family. The resin can be, for example, a thermo hardening resin. Advantageously, a thin cover sheet is deposited on the resin so as to limit the spreading of the resin.

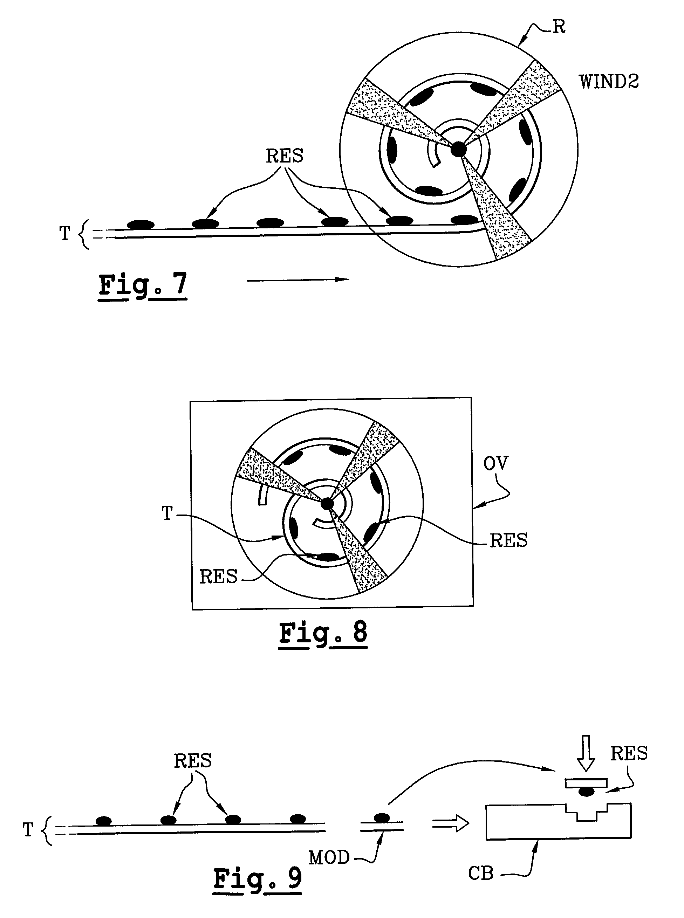

Figure 7 illustrates a second winding step WIND2, in which the basic tape T comprising the connected chips C is wound in a reel R. The resin is between the liquid state and the solid state. That is, the resin is not yet fully hardened. Preferably, the viscosity of the resin is sufficiently high so that the resin does not spread out too much. In practice, the viscosity required depends on the surface tension of the chips. The higher the surface tension is, the higher the viscosity needs to be.
In the resin depositing step RESDEP, the resin can have, for example, a viscosity of 60 000 mPa/s at a temperature of 25°C for chips having an average surface tension of roughly about 30 mN/m. If a thin cover sheet is used, the resin can have for example, a viscosity of 15 000 mPa/s at a temperature of 25°C for chips having an average surface tension of roughly about 30 mN/m.

Figure 8 illustrates a second heating step, which follows the second winding step WIND2. In the second heating step, the reel R comprising the tape T is placed in an oven OV. The temperature may be comprised, for example, between 120°C and 150°C. The tape T can be heated, for example, between 60 minutes and 90 minutes. After the second heating step, the resin RES has reached its definitive, solid state and the chips are thus protected.

Fig. 9 illustrates a cutting step, which follows the second heating step. In the cutting step, a module MOD is cut from the tape T. A module MOD comprises a glued connected chip protected by the resin RES.
Fig. 9 further illustrates an embedding step, in which the module MOD is embedded in a card body CB.

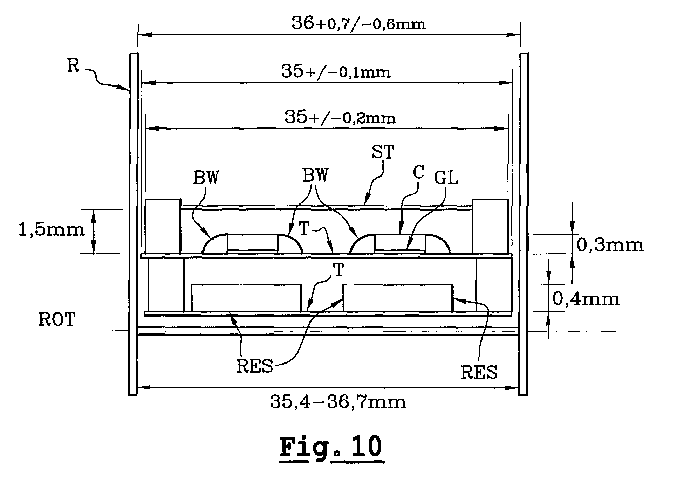

Fig. 10 is a cross section view illustrating a reel R, which can be used in the invention. The reel R comprises a rotation axis ROT. The reel R comprises a spacer tape ST so that the basic tape T is better protected during the first winding step WIND1, the second winding step WIND2 or when, for example, a user carries the reel R. Fig. 10 further illustrates a chip C, which is glued on the basic tape T with glue GL. The chip C comprises bonding wires BW. Fig. 10 also illustrates a chip which is protected with the resin RES. The reel can be made of any material which can resist to the temperatures of the oven. The material can be, for example, a composite material.

The description hereinbefore illustrates the following features:
A tape (T) to which a plurality of elements (C) are affixed by means of a glue in a solid state is manufactured in the following manner. In a gluing step, in which elements (C) are glued to a basic tape (T) by means of a glue in a liquid state so as to obtain a glued tape. The gluing step is followed by a winding step and a heating step. In the winding step, the glued tape (T) is wound while the glue is in a state between the liquid state and the solid state, so as to obtain a winded glued tape. In the heating step, in the winded glued tape is heated, so that the glue reaches the solid state.

There are various manners to implement the invention.
In the above description the chips C are connected to connecting elements CELEM with bonding wires BW. We can also imagine that the chips are connected using other techniques, for example, a flip chip technique.

Any type of glue or resin having a viscosity that limits the spreading in a winding step can be used.

The invention has been described in the context of the manufacturing of a smartcard. But the invention applies more generally to any method, which involves a tape (T) to which a plurality of elements (C) are affixed. It can be a tape comprising, for example, stamps, ducks or any other elements to be affixed on the tape.

## Claims

1. A method of manufacturing a tape (T) to which a plurality of elements (C) are affixed by means of a glue in a solid state, the method comprising a gluing step, in which elements (C) are glued to a basic tape (T) by means of a glue in a liquid state so as to obtain a glued tape, the method being **characterised in that** the gluing step is followed by:
- a winding step, in which the glued tape (T) is wound while the glue is in a state between the liquid state and the solid state, so as to obtain a winded glued tape; and
- a heating step, in which the winded glued tape is heated, so that the glue reaches the solid state.

2. A method of manufacturing a smart card, **characterized in that** the method comprises the method as claimed in claim 1, wherein the elements are formed by semiconductor devices, the method further comprising:
- a cutting step, in which the tape (T) is cut so as to obtain modules (MOD); and
- an embedding step, in which a module (MOD) is embedded in a cardbody (CB) so as to obtain a smart card.
